# EUROPÄISCHE PATENTANMELDUNG

(11) **EP 1 289 016 A2**
(43) Veröffentlichungstag der Anmeldung: **05.03.2003**
(21) Anmeldenummer: 02102202.5
(22) Anmeldetag: 21.08.2002
(51) Int. Cl.: H01L 27/02

(54) **ESD Schutz für CMOS-Ausgangsstufe**

(30) Priorität: 21.08.2001 DE 10139956
(71) Anmelder: Koninklijke Philips Electronics N.V., 5621 BA Eindhoven (NL)
(72) Erfinder: Reiner, Joachim Christian, c/o Philips C.Int.Prop., 52088, Aachen (DE)
(74) Vertreter: Volmer, Georg, Dipl.-Ing.

(57) **Zusammenfassung**

Die Erfindung bezieht sich auf eine Anordnung zur Verbesserung des ESD-Schutzes bei einer integrierten Schaltung. Um eine effektive Chipflächenausnutzung zu erreichen, wird vorgeschlagen, ein passives Bauelement zwischen das Bondpad und eine integrierten Schaltung zu schalten, wobei dieses passive Bauelement über einer elektrisch nicht leitende Schicht und unter dem Bondpad angeordnet ist. Bei Beschädigung des Bondpads beim Bonden oder Testen wird höchstens das passive Bauelement kurzgeschlossen, die Funktionsfähigkeit der Ausgangstreiberstufe und der integrierten Schaltung jedoch nicht beeinflußt.

## Beschreibung

Die Erfindung bezieht sich auf eine Anordnung zur Verbesserung des ESD-Schutzes bei einer integrierten Schaltung.

In integrierten Schaltungen werden CMOS Ausgangstreiberstufen oder auch CMOS-Buffer dazu verwendet, eine entsprechende Verstärkung eines auszugebenden Signals der integrierten Schaltung bereitzustellen. Beispielsweise werden sie bei Anzeigevorrichtungen in Ansteuer- oder Treiberschaltkreisen eingesetzt.

Elektrostatische Entladungen (ESD) gehören zu den destruktivsten, unvermeidbaren Umwelteinflüssen, denen elektronische Systeme und integrierte Schaltungen ausgesetzt sind. So müssen integrierte Schaltungen bei einem ESD-Ereignis innerhalb von Nanosekunden Ströme im Amperebereich leiten. Der zerstörende Einfluß dieser Stromdichten auf die Schaltung liegt einerseits in der sehr hohen thermischen Verlustleistung bezogen auf die Größe des Schaltungselements, andererseits werden Überspannungen auf dem Chip erzeugt, die dünne Oxyde zerstören können. Aus der Sicht der Schaltungsentwicklung in modernen VLSI-Prozessen wird die Beherrschung dieser parasitären Effekte zum zentralen Problem, da die Miniaturisierung die Empfindlichkeit gegenüber ESD-Ereignissen erhöht.

Elektrostatische Ladungen entstehen durch Reibung zwischen Materialien, wie es das Gehen auf Teppichen verursachen kann. Durch Kumulation und Speicherung der Ladung können elektrostatische Potentiale von mehreren kV entstehen. Bei der Berührung von hochintegrierten Halbleiterbauelementen fließen diese gespeicherten Ladungen ab, was auch als elektrostatische Entladung (ESD) bezeichnet wird. Aus elektrischer Sicht stellen elektrostatische Entladungen transiente Hochstromereignisse von mehreren Ampere Spitzenstrom dar, mit einer Dauer von 10 ns bis 300 ns. Diese transienten Ströme gefährden integrierte Schaltungen auf unterschiedliche Arten:
- einerseits können die elektrischen Überlastungen die integrierte Schaltung thermisch zerstören,
- andererseits kann eine Überspannung bei den MOS-Gates Gateoxiddurchbrüche verursachen,
- außerdem können durch mehrfache ESD-Belastungen Degradationserscheinungen auftreten, die eine Erhöhung der Leckströme nach sich ziehen.

Unabhängig von der Art der ESD-Belastung erfährt das Halbleiterbauelement oder die integrierte Schaltung entweder einen irreparablen Schaden oder es wird eine unzureichende oder schlechter werdende Funktionsweise bewirkt.

Mit zunehmender Integrationsdichte von CMOS Prozessen nimmt die Gefahr von Ausfällen integrierter Schaltungen zu, die auf Zerstörung durch elektrostatische Entladungen zurückzuführen sind.

Mittels bekannter ESD Schutzschaltungen wird eine Spannungsbegrenzung vorgenommen. Die eigentliche zu schützende Schaltung muß eine dazu passende Überspannungsfestigkeit aufweisen.

Bei der ständig voranschreitenden Miniaturisierung von integrierten Schaltungen ist außerdem die effektive Ausnutzung der vorhandenen Chipfläche besonders notwendig.

In der WO 0048252 wird eine Anordnung beschrieben, bei der unter dem Bondpad Bauelemente angeordnet sind. Diese sind insbesondere unter dem Rand des Bondpads angeordnet, da dort die Beschädigungen durch mechanische Belastung am geringsten sind. Diese Bauelemente werden durch unterschiedlich dotierte Schichten gebildet, so dass unter dem Bondpad Gebiete existieren, die unterschiedliche elektrische Potentiale aufweisen. Bei Beschädigung des Bondpads können Kurzschlüsse zwischen diesen unterschiedlichen Potentialen die Funktionsfähigkeit der Schaltung beeinträchtigen.

Das Plazieren von Bauelementen unter den Bondpads der CMOS Schaltung zieht den Nachteil nach sich, dass durch das Verbinden des Bondpads, bspw. mittels Bonden, mit den Anschlüssen eines Schaltkreisgehäuses oder Leadframes eine mechanische Belastung auf das Bondpad ausgeübt wird, so dass die unter dem Bondpad befindlichen Schichten u.a. auch aktive Bauelemente, zerstört werden können und somit die Funktionsfähigkeit der integrierten Schaltung nicht gewährleistet ist.

Aufgabe der Erfindung ist es deshalb, eine Anordnung anzugeben, mittels der eine effektive Platzausnutzung der Chipfläche bei Verbesserung des ESD-Schutzes der integrierten Schaltung ermöglicht und bei mechanischer Belastung eines Bondpads die Funktionsfähigkeit der integrierten Schaltung nicht beeinträchtigt wird.

Diese Aufgabe wird erfindungsgemäß durch eine Anordnung zur Verbesserung des ESD-Schutzes bei einer integrierten Schaltung gelöst, bei der zwischen ein Bondpad und der integrierten Schaltung ein passives Bauelement geschaltet ist, das unter dem Bondpad und über einer elektrisch nicht leitenden Schicht angeordnet ist.

Um CMOS-Schaltungen einen ausreichenden ESD-Schutz zu verleihen, sind meist sehr große Widerstände notwendig, die sehr viel Platz auf der Chipoberfläche beanspruchen. Eine typische Ausgangsstufe einer CMOS Schaltung umfaßt wenigstens einen Bondpad, einen PMOS-Transistor, einen NMOS-Transistor, die beide derart verbunden sind, das sie eine Ausgangstreiberstufe bilden. Außerdem ist meist auch eine ESD-Schutzschaltung angeschlossen. Weiterhin können mehrere Dioden zu den unterschiedlichen Potentialen hin geschaltet werden.

Mittels der ESD-Schutzschaltung wird die Spannung im ESD-Fall begrenzt. Wegen des Snapback-Phänomens ist der NMOS-Transistor der Ausgangstreiberstufe besonders gefährdet, während des ESD-Falles durch den hohen fließenden Strom zerstört zu werden. Um diesen Strom zu begrenzen, sind weitere Maßnahmen notwendig. Dazu ist es bekannt, einen Widerstand in Serie zu dem NMOS-Transistor zu schalten, wodurch der Strom begrenzt wird. Da dieser Widerstand jedoch eine ausreichend große Stromfestigkeit aufweisen sollte, muß er entsprechend groß sein. Bei hoch miniaturisierten Schaltungen ist aber gerade der Platz auf der Chipoberfläche sehr begrenzt. Deshalb wird vorgeschlagen, ein passives Bauelement zum zusätzlichen Schutz des NMOS-Transistors unter dem Bondpad zu plazieren.

An dem Bondpad wird mittels Bonden ein Anschlußdraht befestigt. Dieser Draht verbindet das entsprechende Bondpad der integrierten Schaltung mit dem Anschluß am Gehäuse/Leadframe der integrierten Schaltung. Im Vergleich zu der ESD-Schutzschaltung oder der Ausgangstreiberschaltung nimmt das Bondpad den meisten Platz in der Ausgangstufe ein. Während des Testens der Schaltung wird das Bondpad mechanischer Belastung durch Testnadeln ausgesetzt. Auch der Bondvorgang setzt das Bondpad einer hohen mechanischen Belastung aus, gegeben durch die erforderliche Andruckkraft sowie die Ultraschall-vermittelte Kaltverschweißung des Metalles des Bondballes mit dem des Bondpads. Dadurch können Risse in den darunterliegenden Schichten auftreten, die die Funktionsfähigkeit, durch bspw. Leckströme, Kurzschlüsse oder Unterbrechungen, innerhalb dieser Schichten beeinflussen. Deshalb wurden bisher direkt unter den Bondpads keine Bauelemente plaziert, oder wenn nur unter Inkaufnahme einer verminderten Zuverlässigkeit.

Erfindungsgemäß wird unter dem Bondpad ein passives Bauelement plaziert, das zwischen den NMOS Transistor und das Bondpad geschaltet ist. Das Bondpad wird durch mehrere Metallschichten gebildet, die über elektrisch leitende Verbinder oder VIAS verbunden sind. Diese VIAS wirken auch bei Belastung des Bondpads mechanisch stabilisierend. Unter diesen Metallschichten ist erfindungsgemäß ein passives Bauelement angeordnet, das mit einem Anschluß über ein VIA an das Bondpad angeschlossen ist. An den anderen Anschluß des passiven Bauelements ist die integrierten Schaltung, insbesondere die Ausgangstreiberstufe, angeschlossen. Dadurch wird erreicht, dass im ESD Fall ein hoher Stromfluß mittels des passiven Bauelements begrenzt wird. Durch die Anordnung des passiven Bauelements unter den Metallschichten werden bei Zerstörung oder Beschädigung der Metallschichten durch mechanischen Druck auf das Bondpad im extremsten Fall nur Leckstrompfade entstehen, welche das passive Bauelement überbrücken, in dem z.B. eine isolierende Schicht Risse bekommt, durch die Metall gepreßt werden könnte und somit das passive Bauelement überbrückt werden könnte. Durch diesen Leckstrompfad wird jedoch die Funktionsfähigkeit der ESD-Schutzschaltung, der Ausgangstreiberschaltung und auch der integrierten Schaltung nicht beeinflußt. Dazu wird vorzugsweise ausschließlich das passive Bauelement unter dem Bondpad angeordnet und außerdem wird dieses auf einer elektrisch nicht leitenden Schicht angeordnet, so dass bei Beschädigung und eventuellem Kurzschluß keine weiteren Bauteile kurzgeschlossen werden können und die Funktionsfähigkeit beeinträchtigen können.

In einer bevorzugten Ausführungsform wird vorgeschlagen, das passive Bauelement zu segmentieren. Dadurch wird erreicht, dass bei starkem mechanischen Druck, das passive Bauelement nicht zerstört wird, sondern einer Rißausbreitung durch die Segmentierung vorgebeugt wird. Im Falle einer Beschädigung der Metallschichten wird erreicht, dass ein Teil des passiven Bauelements überbrückt wird, die Funktionsfähigkeit der CMOS Ausgangstreiberstufe aber nicht beeinträchtigt wird. Die Segmentierung besteht darin, dass das passive Bauelement nicht aus einem zusammenhängenden Gebiet gebildet wird, sondern aus vielen kleinen Teilgebieten.

Vorzugsweise wird die nicht leitende Schicht über einer n-(p-)dotierten Schicht in einem p-(n-)dotierten Substrat ausgebildet, so dass bei Beschädigung und Rißbildung in der nicht leitenden Schicht unter dem passiven Bauelement diese entsprechend dotierte Schicht gegen weitere Kurzschlüsse sperrt.

Es ist ebenfalls vorteilhaft, das passive Bauelement unter einer isolierenden Feldoxidschicht als schwach n-dotierte Schicht auszubilden. Da die schwach n-dotierte Schicht einen hohen Widerstand aufweist, wird damit wenig Platz beansprucht. Ebenso ist es möglich, das Feldoxid über einer p-dotierten Schicht anzuordnen.

In einer besonderen Ausführungsform ist das passive Bauelement durch einen Widerstand aus Polysilizium realisiert. Dieser Polysilizium-Widerstand ist über einer isolierenden Feldoxidschicht angeordnet. Um den Widerstand von anderen elektronischen Strukturen zu separieren, wird vorgeschlagen unter der Feldoxidschicht, die unter dem Widerstand liegt, eine schwach n-(p-)dotierte Schicht im p-(n-)dotierten Substrat anzuordnen.

Die Verwendung von Polysilizium ist deshalb vorteilhaft, da keine zusätzliche Diffusionsschicht im Substrat notwendig ist, welche bei ungünstiger Anordnung zu einer Latchup-Empfindlichkeit der Ausgangstreiberstufe führen könnte. Durch die außerdem vorteilhafte Plazierung einer schwach n-(p-)dotierte Schicht im p-(n-)dotierten Substrat unter der Feldoxidschicht wird die Toleranz gegen Kurzschlußbildung auf Grund der mechanischen Belastung erhöht, falls ein Riß bis in das Feldoxidschicht vordringt. In einem derartigen Fall sperrt der Übergang zwischen der schwach n-(p-)dotierte Schicht und dem p-(n-)dotierten Substrat.

In einer weiteren vorteilhaften Ausgestaltung der Erfindung ist vorgesehen, mehrere Widerstände zwischen den NMOS-Transistor und das Bondpad zu schalten. Auch durch die Anschlußverbindungen zwischen dem VIA und dem Widerstandsanschluß wird jeweils ein Widerstand gebildet, der im ESD-Fall auch zur Begrenzung eines zu hohen Stromflusses beitragen kann. Durch geeignete Materialwahl kann hier ein schlecht leitendes Material gewählt werden, wodurch ein großer Widerstand gebildet wird, der wenig Platz beansprucht.

Ein Widerstand kann auch aus anderen Schichten aufgebaut werden, z.B. als n-well dotierte Schicht in einer p-dotierten Schicht oder als n+ -dotierte Schicht über einer p-dotierten Schicht oder p+-dotierten Schicht über einer n-dotierten Schicht. Auch eine Realisierung als Metallschicht über einer Feldoxidschicht ist ebenfalls möglich. Dabei ist ein Widerstand aus n-well unter der Feldoxid-Schicht noch besser mechanisch gegen Belastung geschützt. Bei einer Realisierung eines Widerstands aus n+ oder p+ dotierten Schichten ist die Widerstandsschicht nicht von einem Feldoxid abgedeckt und liegt tiefer und damit geschützter als eine Polysiliziumschicht liegen würde. Auch eine Realisierung des Widerstands durch eine Metallschicht ist möglich, da bei Beschädigung des Bondpads höchstens der Widerstand kurzgeschlossen werden könnte. Es ist ebenfalls möglich die aufgezählten Arten von Widerstände zu kombinieren, so dass bspw. unter dem Bondpad ein Widerstand aus Polysilizium gebildet wird, der aber außerhalb des Bondpads mit einem Widerstand in einem n-well Gebiet in Serie geschaltet ist.

Ebenso ist es möglich, den Widerstand durch die Metall1-schich zu bilden. Diese Schicht ist bei heutigen CMOS-Technologien vorzugsweise aus Wolfram ausgebildet, so dass durch den hohen Widerstand von Wolfram wenig Fläche notwendig ist, um einen großen Widerstand auszubilden oder unter der gesamten Fläche des Bondpad ein sehr großer Widerstand gebildet werden kann.

Für Hochfrequenzanwendungen ist es vorteilhaft das passive Bauelement unter dem Bondpad als Kondensator oder als Spule auszubilden, wobei auch diese bei einem hochohmigen Leckstrompfad noch nicht die Funktionsfähigkeit der integrierten Schaltung beeinflussen.

Die Aufgabe wird auch durch eine Anordnung zur Ansteuerung einer Anzeigevorrichtung gelöst, die eine CMOS-Treiberschaltung aufweist. Da die Spannungen, die zur Ansteuerung von Displays notwendig sind, meist über den Betriebsspannungen liegen, müssen durch Treiberschaltungen und eventuelle Ladungspumpen die notwendigen Spannungen bereitgestellt werden. Dazu wird u.a. auch eine oben beschriebene Anordnung benötigt.

Nachfolgend werden anhand der Zeichnungen Ausführungsbeispiele näher beschrieben. Es zeigen:
- Fig. 1:: schematische Darstellung einer CMOS-Ausgangsstufe
- Fig.2:: Widerstand unter dem Bondpad
- Fig.3:: mehrere Widerstände in schematischer Darstellung
- Fig.4:: segmentierter Widerstand

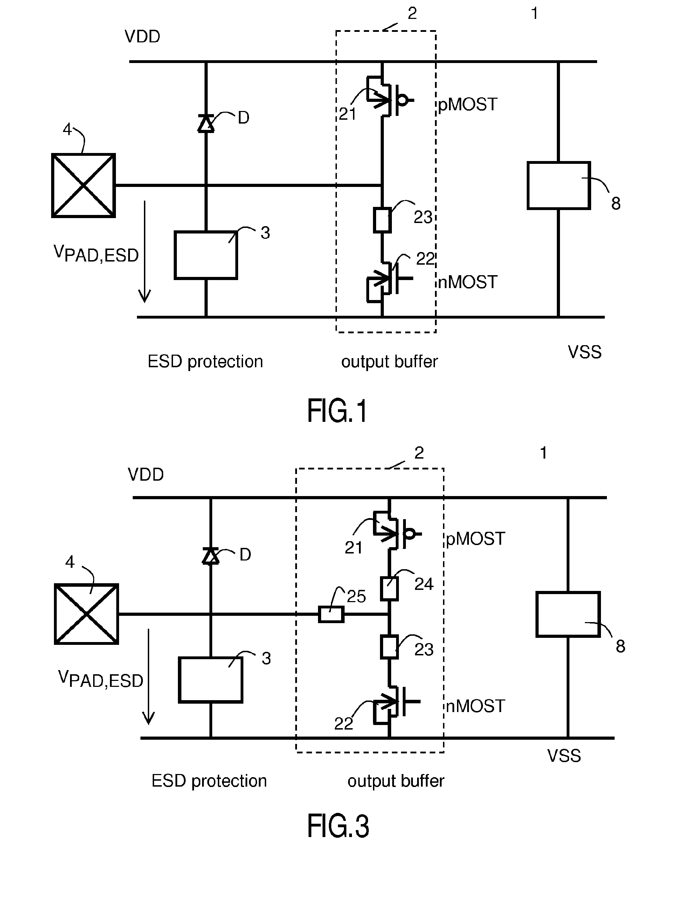

In Figur 1 ist eine vereinfachte Darstellung einer CMOS Ausgangsstufe 1 dargestellt.

Die Ausgangstreiberstufe 2 umfaßt wenigstens einen PMOS Transistor 21 der in Serie mit dem NMOS Transistor 22 geschaltet ist. Die beiden Transistoren sind typischerweise zwischen Vdd und Vss geschaltet. Im ESD-Fall fließt ein sehr großer Strom über den NMOS Transistor 22, wodurch dieser eventuell zerstört werden könnte. Um diesen Strom zu begrenzen, ist ein Widerstand 23 zwischen die beiden Transistoren geschaltet. Dieser Widerstand ist auf der einen Seite mit dem Drain-Anschluß des NMOS-Transistors 22 verbunden. Die andere Seite des Widerstandes 23 ist mit dem PMOS Transistor 21 und dem Bondpad 4 verbunden. Zwischen das Bondpad und Vss ist außerdem noch eine Überspannungsschaltung 3 geschaltet, die im ESD Fall die Spannung V_{pad} am Bondpad 4 auf V_{pad,esd} begrenzt. Außerdem ist zwischen Vdd und Vss eine ESD Schutzschaltung 8 angeordnet. Eine Diode D ist zwischen den Eingang/Ausgang der integrieren Schaltung und Vdd geschaltet und stellt einen zusätzlichen ESD-Ableitungspfad über VDD und die Schutzschaltung 8 dar.

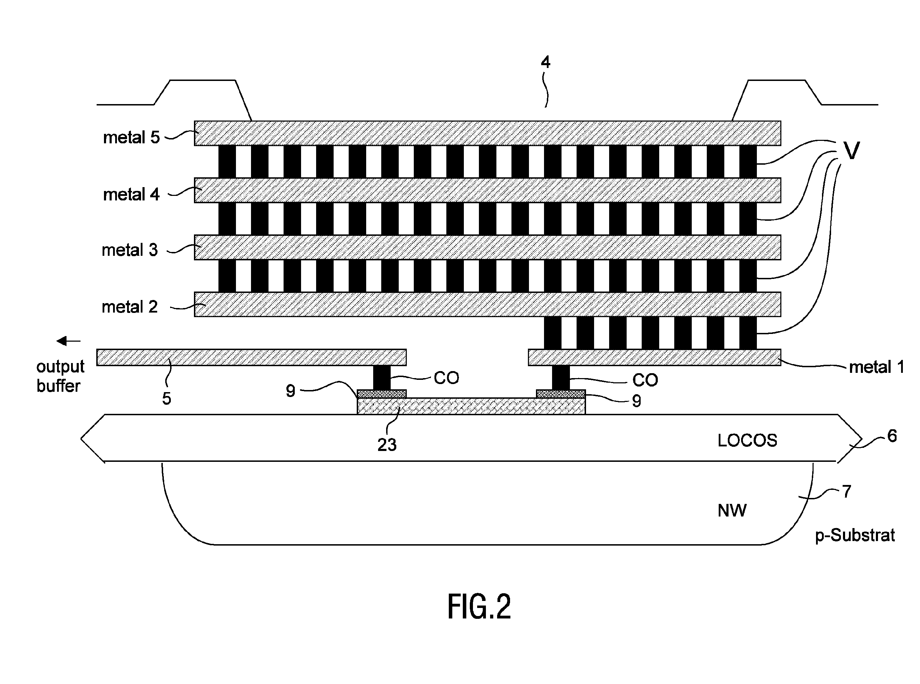

Figur 2 zeigt die Anordnung eines Widerstandes 23 unter dem Bondpad 4. Das Bondpad wird durch mehrere Metallschichten Metall 1-5 gebildet. Diese Metallschichten sind über VIAS V, die elektrisch leitend sind, verbunden. Der Widerstand 23 ist an wenigstens einen Kontakt-VIA CO angeschlossen. Die andere Seite des Widerstandes ist an die Ausgangstreiberstufe 2 angeschlossen. Unter dem Widerstand 23 ist eine Feldoxidschicht 6 angeordnet, die elektrisch nicht leitend ist. Diese Feldoxidschicht 6 ist über einem n-well Gebiet 7 angeordnet, das in ein schwach p-dotiertes Substrat eingebettet ist. Die Kontakt-VIAs sind an Silizidschichten 9 befestigt. Diese Silizidschichten 9 weisen ebenfalls einen elektrischen Widerstand auf. Der Bereich 10 zwischen den Silizidschichten 9 ist mittels SIPROT-Maske nicht mit Silizid bedeckt worden. Da Silizid einen niedrigeren Widerstand aufweist, als Polysilizium, würde mit einem vollständig mit Silizid bedeckten Polysilizium-Widerstand 23 der Widerstandswert unnötig verringert werden.

Bei einer Beschädigung des Schichtaufbaus kann es vorkommen, das die isolierende Schicht zwischen Metall 2 und Metal 1/Anschlußpfad 5 Risse bekommt, durch die die Metallschichten gepreßt werden können und einen Leckstrompfad zwischen der Metallschicht Metall 2 und dem Anschlußpfad 5 der Ausgangstreiberstufe hervorrufen könnten. Dies kommt einem Kurzschluß des Widerstands 23 gleich. Durch diesen Kurzschluß wird dieser Widerstand 23 überbrückt, die Funktionsfähigkeit der Ausgangstreiberstufe und auch einer nicht dargestellten integrierten Schaltung jedoch nicht beeinträchtigt. Da der Widerstand über einer isolierenden Feldoxidschicht 6 angeordnet ist, kann sich der Kurzschluß auch nicht auf andere aktive Gebiete erstrecken. Außer dem Widerstand sind unter dem Bondpad 4 keine weiteren Bauelemente angeordnet, deren Funktionsfähigkeit beeinträchtigt werden könnte. In der Regel haben Leckstrompfade, die durch mechanische Beschädigung der isolierenden Schicht entstehen, aufgrund ihrer meist geringen räumlichen Ausdehnung einen relativ hohen Widerstand, typischerweise in der Größe einiger kOhm. Da der hier vorgeschlagene Widerstand Werte von etwa 1 bis 1000 Ohm hat, beeinflußt ein solcher Leckstrompfad die Funktion der Ausgangsstufe nur unwesentlich.

Dies steht im Gegensatz zu einem Leckstrompfad beispielsweise zwischen dem Bondpad und VDD oder VSS, wo Leckstrompfade mit 1 MegaOhm Widerstand bereits dazu führen, dass ein typisches CMOS-Bauteil die Spezifikation von etwa 1 µA maximalem Leckstrom nicht mehr erfüllt und damit elektrisch ausfällt.

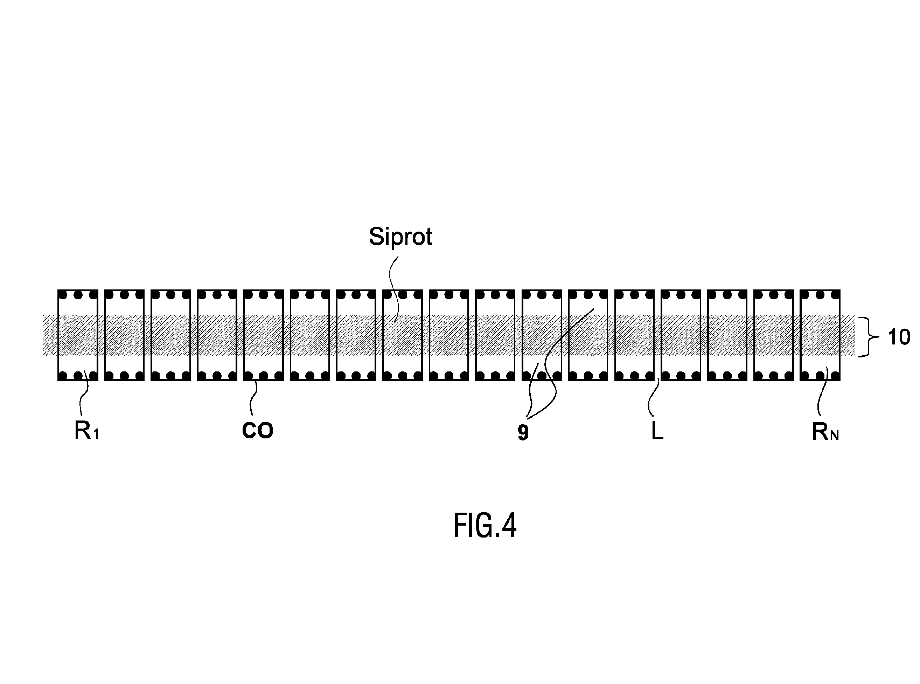

Figur 3 zeigt eine Darstellung mit mehreren Widerständen, die derart miteinander verbunden sind, daß ein größerer Widerstand gebildet sind. Diese Widerstände 23, 24, 25 können erfindungsgemäß wenigstens teilweise unter dem Bondpad 4 angeordnet sein.

Figur 4 zeigt einen segmentierten Widerstand. Dabei sind die Teilflächen R₁-Rₙ aus Polysilizium ausgebildet. Diese Flächen R₁-Rₙ sind auf beiden Seiten der Kontakte CO mit einem einer Silizidschicht 9 miteinander verbunden. Mittels einer SIPROT Maske wird dabei lokal die Bildung und auch die Breite der Silizidschicht beeinflußt. Durch die Auswahl des Materials der Kontakte CO zu der Metallschicht Metall1 und die Breite der nicht silizidierten Fläche des Widerstandes kann die Größe des Widerstands eingestellt werden. Die Flächen R₁-Rₙ sind mit Lücken L zwischen den Flächen angeordnet, so dass sich bei Rißbildung ein Riß nicht durch den gesamten Widerstand fortsetzen kann.

Durch die SIPROT Maske wird das Aufbringen der Silizidschicht verhindert, da diese Silizidschicht niederohmig ist (ca 5 Ohms/square) und den Widerstandswert klein halten würde. Durch die SiPROT-Maske erhält man lokal unsilizidiertes Polysilizium mit etwa 100 Ohms/square.

Das konkrete Beispiel stellt einen CMOS-Ausgang dar, der als Displaytreiberausgang verwendet werden kann, aber beispielsweise auch als Datenausgang eines Logikchips.

## Patentansprüche

1. Anordnung zur Verbesserung des ESD-Schutzes einer integrierten Schaltung bei der zwischen einen Bondpad und der integrierten Schaltung ein passives Bauelement geschaltet ist, das unter dem Bondpad und über einer elektrisch nicht leitenden Schicht ausgebildet ist.

2. Anordnung nach Anspruch 1,
**dadurch gekennzeichnet,**
**dass** die integrierte Schaltung zur Bildung einer Ausgangstreiberstufe wenigstens einen PMOS-Transistor und einen zu diesem in Serie geschalteten NMOS-Transistor aufweist und das passive Bauelement zwischen dem PMOS und den NMOS Transistor angeordnet ist und vorgesehen ist, einen Strom im ESD-Fall ohne Zerstörung des NMOS Transistors zu reduzieren.

3. Anordnung nach Anspruch 1,
**dadurch gekennzeichnet,**
**dass** das Bondpad von einer Vielzahl von Metallschichten gebildet ist, wobei die Metallschichten über elektrisch leitende und mechanisch stabilisierende Verbinder (VIAS) miteinander verbunden sind und das passive Bauelement mit einem Anschluß wenigstens mit einer dieser Metallschichten und mit dem anderen Anschluß mit der Ausgangstreiberstufe verbunden ist.

4. Anordnung nach Anspruch 1,
**dadurch gekennzeichnet,**
**dass** bei Beschädigung wenigstens einiger Metallschichten und wenigstens teilweisem Kurzschluß zwischen Metallschichten des Bondpads und dem Anschlußpfad zur integrierten Schaltung die Funktionsfähigkeit der Ausgangstreiberstufe und/oder der integrierten Schaltung erhalten bleibt.

5. Anordnung nach Anspruch 1,
**dadurch gekennzeichnet,**
**dass** das passive Bauelement segmentiert ausgebildet ist, um einer Rißbildung entgegen zu wirken.

6. Anordnung nach Anspruch 1,
**dadurch gekennzeichnet,**
**dass** die elektrisch nicht leitende Schicht über einem n-dotierten oder p-dotierten-Substrat angeordnet ist.

7. Anordnung nach Anspruch 1,
**dadurch gekennzeichnet,**
**dass** das passive Bauelement durch eine widerstandsbehaftete Schicht aus Polysilizium gebildet wird und wenigstens einen Widerstand bildet.

8. Anordnung nach Anspruch 7,
**dadurch gekennzeichnet,**
**dass** die widerstandsbehaftete Schicht aus einem Metall gebildet wird.

9. Anordnung nach Anspruch 1,
**dadurch gekennzeichnet,**
**dass** das passive Bauelement als wenigstens ein Kondensator ausgebildet ist.

10. Anordnung nach Anspruch 1,
**dadurch gekennzeichnet,**
**dass** das passive Bauelement als wenigstens eine Spule ausgebildet ist.

11. Anordnung zur Ansteuerung von Anzeigevorrichtungen mit einer Anordnung nach den Ansprüchen 1-10.
